**Europäisches Patentamt**

(19) **European Patent Office**

**Office européen des brevets**

(11) Numéro de publication: **0 125 984 B1**

(12) # FASCICULE DE BREVET EUROPEEN

(45) Date de publication du fascicule du brevet:
**26.08.87**

(51) Int. Cl.⁴: **H 03 K 5/08, H 04 L 25/30**

(21) Numéro de dépôt: **84400913.4**

(22) Date de dépôt: **04.05.84**

(54) **Procédé pour remettre en forme un signal numérique déformé et dispositif pour la mise en oeuvre dudit procédé.**

(30) Priorité: **10.05.83 FR 8307806**

(43) Date de publication de la demande:
**21.11.84 Bulletin 84/47**

(45) Mention de la délivrance du brevet:
**26.08.87 Bulletin 87/35**

(84) Etats contractants désignés:
**DE GB IT NL SE**

(56) Documents cités:
**US - A - 4 339 727**

(73) Titulaire: **Milon, Jean, Kerlessanouet,**
**F-22700 Perros-Guirec (FR)**
Titulaire: **Kerdiles, Jean-François, Landrellec,**
**F-22560 Pleumeur-Bodou (FR)**

(72) Inventeur: **Milon, Jean, Kerlessanouet,**
**F-22700 Perros-Guirec (FR)**
Inventeur: **Kerdiles, Jean-François, Landrellec,**
**F-22560 Pleumeur-Bodou (FR)**

(74) Mandataire: **Mongrédien, André et al, c/o**
**BREVATOME 25, rue de Ponthieu, F-75008 Paris (FR)**

## Description

La présente invention concerne un procédé pour régénérer un signal numérique déformé et un dispositif pour la mise en œuvre de ce procédé. Cette invention trouve notamment son application en transmission numérique dans les récepteurs de signaux numériques.

Une transmission numérique consiste en un émetteur E, un canal de transmission C, et un récepteur R. L'émetteur E envoie des impulsions dans le canal de transmission C. Ce canal de transmission C constitue un filtre qui déforme les impulsions émises par l'émetteur E. En particulier, si le canal de transmission C comprend des transformateurs, ceux-ci passent mal les fréquences basses. Par ailleurs, le câble affaiblit les fréquences élevées. En sortie du canal de transmission C, les impulsions sont donc déformées. Elles sont allongées et peuvent même se chevaucher entre elles. Dans la majorité des cas, le récepteur R ne peut donc pas les détecter de manière simple.

Pour réaliser cette réception, l'homme de l'art utilise de façon connue un égaliseur pour compenser la distorsion d'affaiblissement du câble et un filtre complémentaire de Nyquist pour séparer les impulsions se chevauchant. Cette solution a plusieurs inconvénients. L'égaliseur favorise les fréquences élevées, donc en particulier les parasites haute fréquences, et rend plus complexe la réalisation du filtre passe-bas associé. D'autre part, ce type de récepteur élimine les signaux comportant une composante basse fréquence à cause de la difficulté qu'il y a à égaliser de tels signaux. Enfin, l'utilisation d'un filtre de Nyquist fait de ce récepteur un dispositif complexe.

On connaît également un circuit de remise en forme d'un signal numérique déformé, notamment par le document US-A-4 339 727. Ce circuit comporte un filtre RC et consiste à élaborer un signal intermédiaire égal à la valeur moyenne du signal déformé, et à comparer lesdits signaux pour restituer le signal numérique. Dans un mode de réalisation particulier, des diodes sont utilisées pour limiter la différence d'amplitude du signal déformé et du signal intermédiaire. La tension de conduction des diodes est supérieure à la tension crête du signal déformé.

La présente invention a pour objet de remédier aux inconvénients des circuits connus. L'invention vise un procédé de traitement simple du signal reçu par le récepteur R pour remettre en forme ce signal numérique déformé à l'aide d'un signal intermédiaire différent de celui du document US-A-4 399 727. Elle vise également un dispositif simple, économique et performant pour la mise en œuvre de ce procédé.

De manière plus précise, l'invention a pour objet un procédé pour remettre en forme un signal numérique déformé, dans lequel on élabore, à partir du signal S, un signal analogique intermédiaire SI, la différence, en valeur absolue, entre l'amplitude du signal analogique SI et l'amplitude du signal S étant maintenue à une valeur au plus égale à une première valeur prédéterminée ΔX, et on compare lesdits signaux SI et S, le résultat de cette comparaison fournissant un signal binaire SN constituant une remise en forme du signal S, ledit procédé étant caractérisé en ce que ladite première valeur prédéterminée ΔX est inférieure à la valeur crête du signal S, et en ce que, en outre, on maintient la pente, en valeur absolue, du signal intermédiaire SI au plus égale à une deuxième valeur prédéterminée ΔP, tant que la différence des amplitudes des signaux SI et S reste, en valeur absolue, inférieure à ΔX, ladite deuxième valeur prédéterminée ΔP étant inférieure à la pente des transitions utiles du signal S et le signe de cette pente ΔP étant égal à celui du signe de la différence SI-S.

Par transition utile du signal S, on entend une transition qui représente une information, c'est-à-dire une transition réelle du signal binaire ou bipolaire émis. La pente ΔP doit être inférieure à la pente des transitions utiles. Elle ne doit pas être cependant trop faible car elle doit être également supérieure à la pente des signaux parasites du signal S.

L'invention a aussi pour objet un dispositif pour la mise en œuvre du procédé comprenant un moyen d'élaboration d'un signal intermédiaire SI recevant sur une entrée le signal S et délivrant sur une sortie le signal intermédiaire SI, ledit moyen d'élaboration comprenant un premier moyen 10 pour limiter la différence entre l'amplitude du signal intermédiaire SI et l'amplitude du signal S à une première valeur prédéterminée ΔX, ledit premier moyen étant relié à l'entrée et à la sortie du moyen d'élaboration, ledit dispositif comprenant en outre un moyen de comparaison 16 recevant sur son entrée inverseuse le signal S et sur son entrée non-inverseuse le signal intermédiaire SI et délivrant un signal binaire SN appliqué sur l'entrée d'un inverseur 17 qui délivre le signal SN identique au signal S avant déformation, ledit dispositif étant caractérisé en ce que ladite valeur prédéterminée ΔX est inférieure à la valeur crête du signal S et en ce que ledit moyen d'élaboration est muni d'une entrée de commande et comprend en série un moyen d'inversion 14 et un deuxième moyen 12, l'entrée dudit moyen d'inversion étant reliée à l'entrée de commande du moyen d'élaboration 10 et la sortie du deuxième moyen 12 étant reliée à la sortie dudit moyen d'élaboration, ledit moyen d'inversion délivrant un courant d'intensité I constante et de signe fixé par l'état binaire du signal SN.

Selon une caractéristique secondaire du dispositif selon l'invention, le premier moyen est constitué de deux diodes identiques montées en parallèle, l'anode d'une diode étant reliée à la cathode de l'autre diode.

Selon une autre caractéristique secondaire, le deuxième moyen est constitué d'un condensateur.

Les caractéristiques et avantages de l'invention ressortiront mieux de la description qui va suivre, donnée à titre illustratif mais non limitativ, en référence aux dessins annexés dans lesquels:

– la figure 1 est un diagramme représentant différents signaux numériques,

– la figure 2 est un schéma des états du signal intermédiaire SI,

– la figure 3 est un organigramme montrant les règles d'évolution temporelle du signal intermédiaire SI,

– la figure 4 est un diagramme schématique représentant un dispositif pour la mise en œuvre du procédé selon l'invention,

– la figure 5 est un schéma illustrant un mode de réalisation du dispositif selon l'invention.

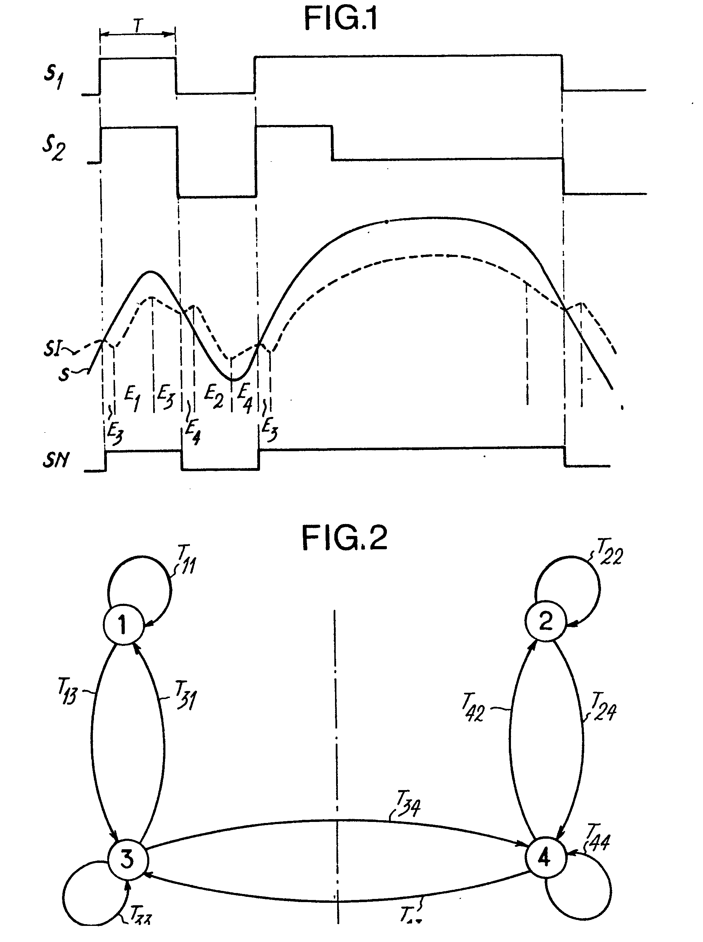

Le signal numérique $S_1$ de la figure 1 représente un signal binaire à émettre par l'émetteur E. Ce signal est effectivement émis dans le canal de transmission C après codage. Ce codage peut être par exemple bipolaire, tel que représenté en $S_2$ de la figure 1 ou autre. Le canal de transmission C déforme le signal émis en ne passant pas les fréquences basses et en affaiblissant les fréquences élevées. Ceci se produit notamment par un élargissement, et éventuellement des chevauchements, des impulsions.

Le signal reçu par le récepteur numérique R, et correspondant au signal émis par l'émetteur E, a alors l'allure du signal S.

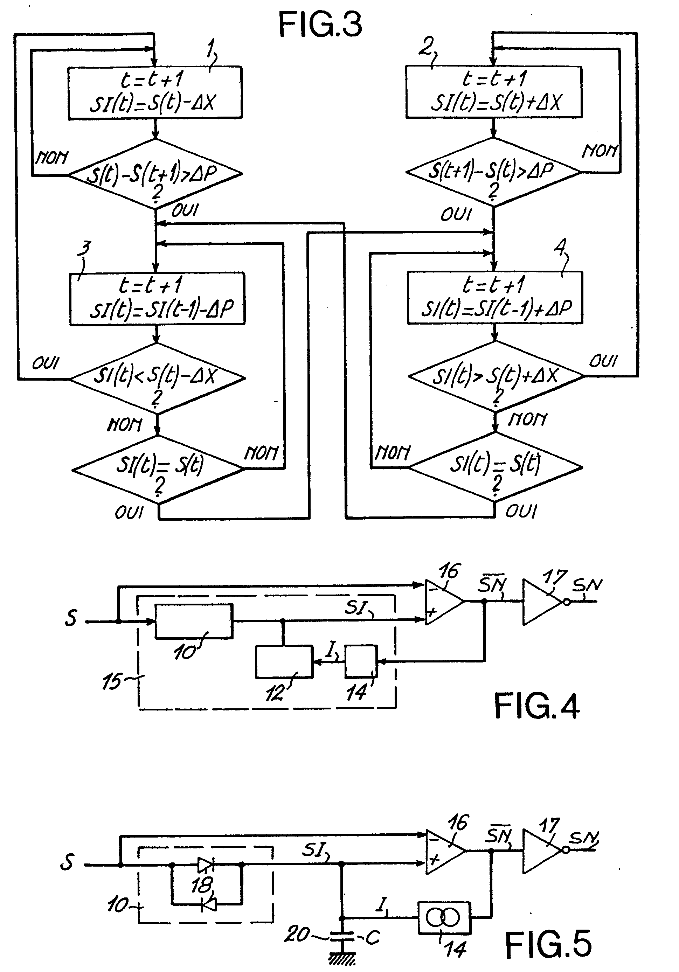

Pour retrouver le signal original émis par l'émetteur E, il suffit de retrouver dans le signal S représenté en trait plein sur la figure, les transitions du signal émis. Ceci est obtenu dans le procédé selon l'invention par l'élaboration d'un signal intermédiaire SI représenté en traits tiretés sur la figure 1. Les règles d'obtention et d'évolution du signal intermédiaire SI seront détaillées en référence aux figures 2 et 3. Ce signal intermédiaire SI est construit de telle sorte que son amplitude soit égale à celle du signal S à chaque transition du signal numérique $S_1$. Par comparaison des signaux SI et S, on peut donc engendrer un signal SN dont les transitions sont identiques à celles du signal $S_1$.

On remarque sur la figure 1 que le signal intermédiaire SI peut être décrit comme étant régi par quatre états d'évolutions différents $E_1$, $E_2$, $E_3$ et $E_4$. Dans le premier état $E_1$, la pente du signal SI est égale à la pente du signal S et l'amplitude du signal SI est inférieure à l'amplitude du signal S; dans le deuxième état $E_2$, le pente du signal SI est toujours égale à la pente du signal S, mais l'amplitude du signal SI est supérieure à l'amplitude du signal S; dans le troisième état $E_3$, la pente du signal SI est constante et décroissante, et dans le quatrième état $E_4$, la pente du signal SI est constante et croissante.

On peut exprimer les deux étapes de la séquence d'élaboration du signal intermédiaire SI du procédé selon l'invention à l'aide de ces quatre états. La première étape est constituée de la succession des états $E_2$ puis $E_4$ ou de la succession des états $E_1$ puis $E_3$. L'état $E_2$, ou l'état $E_1$ correspond à la partie de l'étape où la première contrainte est atteinte, et où par conséquent la deuxième contrainte est ignorée, ou où aucune contrainte n'est atteinte, le signal intermédiaire SI suivant librement le signal S. Dans cette première étape, la différence entre l'amplitude du signal intermédiaire SI et l'amplitude du signal S est toujours égale à la première valeur prédéterminée ΔX. L'état $E_4$, ou l'état $E_3$ correspond à la partie de l'étape où la deuxième contrainte est atteinte. La deuxième étape est constituée de l'état $E_4$ ou de l'état $E_3$.

On va maintenant décrire plus en détail, en référence aux figures 2 et 3, les quatre états qui viennent d'être mentionnés et les règles de transition d'un état à un autre.

On a représenté sur la figure 2 un graphe des états du signal SI et des transitions entre ces états. La transition entre un état $E_i$ et un état $E_j$, où i et j sont compris entre 1 et 4, est représentée par $T_{ij}$. Dans le cas où i est égal à j, la transition $T_{ij}$ exprime que le signal intermédiaire SI reste dans l'état $E_i$. Chacun de ces quatre états caractérise une loi particulière d'évolution du signal intermédiaire SI. Les transitions $T_{ij}$ entre un état $E_i$ et un état $E_j$, où i et j sont des entiers compris entre 1 et 4, apparaissent précisément lorsque l'une, ou les deux contraintes sont atteintes, ou lorsqu'une condition particulière est réalisée, telle que l'égalité entre l'amplitude du signal intermédiaire SI et l'amplitude du signal S. Les transitions du type $T_{ii}$ expriment le maintien dans l'état $E_i$.

On va maintenant décrire les équations régissant l'évolution du signal intermédiaire SI dans chacun des états et les contraintes ou conditions correspondant aux transitions entre ces états.

Dans l'état $E_1$, le signal intermédiaire SI a, à chaque instant, une amplitude égale à celle du signal S minoré de la valeur prédéterminée ΔX. On reste dans cet état tant que la pente du signal S est supérieure à l'opposé de la valeur prédéterminée ΔP. Ceci est exprimé par la transition $T_{11}$. Si la pente du signal S devient inférieure à l'opposé de la valeur prédéterminée ΔP, il y a transition $T_{13}$ de l'état $E_1$ à l'état $E_3$.

Dans cet état $E_3$, le signal intermédiaire SI a une pente constante qui est égale en module à la valeur prédéterminée ΔP et dont le signe est négatif, Cet état peut être quitté pour une transition vers l'état $E_1$, lorsque la première contrainte est atteinte. Il peut également être abandonné pour l'état $E_4$, par la transition $T_{34}$ lorsque l'amplitude du signal S est égale à l'amplitude du signal intermédiaire SI.

Dans l'état $E_4$, la pente du signal intermédiaire SI est égale en valeur absolue à ΔP, comme dans l'état $E_3$, mais son signe est positif. Ainsi qu'on peut le remarquer sur la figure 1, il y a deux moyens de quitter cet état $E_4$. Une transition apparaît lorsque l'amplitude du signal intermédiaire SI est égale à l'amplitude du signal S. Cette transition $T_{34}$ fait passer de l'état $E_4$ à l'état $E_3$. Une autre transition est possible à partir de l'état $E_4$. Elle apparaît lorsque la différence d'amplitude entre le signal intermédiaire SI et le signal S devient supérieure à la valeur prédéterminée ΔX. On passe alors par la transition $T_{42}$ de l'état $E_4$ à l'état $E_2$.

Le quatrième et dernier état est l'état $E_2$. Dans cet état, le signal SI a, à chaque instant, une amplitude égale à celle du signal S augmenté de la valeur prédéterminée ΔX. On reste dans cet état tant que la pent du signal S reste inférieure à la deuxième valeur prédéterminée $\Delta P$. Lorsque cette contrainte est atteinte, on passe de l'état $E_2$ à l'état $E_4$ par la transition $T_{24}$.

Sur la figure 3, on a représenté l'organigramme décrivant l'évolution du signal intermédiaire SI en fonction du temps et qui correspond au graphe de la figure 2. Le signal intermédiaire SI élaboré au moyen de cet organigramme est connu par son amplitude à des instants $T_0$, $t_0+1$, $t_0+2$, etc.... Cette discrétisation du signal intermédiaire SI élaboré n'a pour but qu'une présentation plus claire de l'organigramme. Elle ne saurait limiter l'invention à l'élaboration d'un signal intermédiaire SI discret. En effet, un signal continu peut être simplement considéré comme étant un signal discret dont la fréquence d'échantillonnage est extrêmement élevée.

Les références 1, 2, 3 et 4 représentent respectivement les règles d'évolution du signal intermédiaire SI dans les états $E_1$, $E_2$, $E_3$ et $E_4$. Supposons qu'à un instant t, on se trouve dans l'état 1. L'amplitude du signal intermédiaire SI est alors égale à l'amplitude du signal S au même instant t minoré de la valeur prédéterminée $\Delta X$. On va chercher à déterminer maintenant l'amplitude du signal intermédiaire SI à l'instant successif t+1. Pour cela, on compare la pente entre les instants t et t+1 du signal S à la valeur prédéterminée $\Delta P$. Si la décroissance du signal S entre t et t+1 est supérieure à $\Delta P$, on passe dans l'état $E_3$. Dans le cas contraire, on reste dans l'état $E_1$. Le premier cas correspond à la transition $T_{13}$ de la figure 2 et le second cas à la transition $T_{11}$.

Lorsque l'on est dans l'état $E_3$, l'amplitude du signal intermédiaire SI à un instant quelconque est égale à l'amplitude de ce même signal à l'instant précédent diminué de la valeur prédéterminée $\Delta P$. Si, en diminuant ainsi d'une valeur $\Delta P$, l'amplitude du signal intermédiaire SI devient inférieure à un instant donné à l'amplitude du signal S au même instant minoré de la valeur prédéterminée $\Delta X$, on repasse dans l'état $E_1$. Ceci correspond à la transition $T_{31}$ de la figure 2. Dans le cas contraire, selon que l'amplitude du signal intermédiaire SI est égale à l'amplitude du signal S ou non, on passe dans l'état $E_4$ (c'est la transition $T_{34}$) ou on reste dans l'état $E_3$ (c'est la transition $T_{33}$).

Lorsque l'on est dans l'état $E_4$, l'amplitude du signal intermédiaire SI à un instant donné est égale à son amplitude à l'instant précédent augmentée de la valeur prédéterminée $\Delta P$. Si, en augmentant de la valeur $\Delta P$, l'amplitude du signal intermédiaire SI devient supérieure à l'amplitude, au même instant, du signal S augmenté de la valeur prédéterminée $\Delta X$, on passe dans l'état $E_2$ (c'est la transition $T_{42}$). Dans le cas contraire, selon que l'amplitude du signal intermédiaire SI devient égale ou non à l'amplitude du signal S à la suite d'une augmentation de la valeur $\Delta P$, on passe dans l'état $E_3$ (c'est la transition $T_{43}$) ou on reste dans l'état $E_4$ (c'est la transition $T_{44}$).

Lorsque l'on est dans l'état $E_2$, l'amplitude du signal intermédiaire SI est égale à un instant donné, à l'amplitude du signal S au même instant augmentée de la valeur prédéterminée $\Delta X$. Si, alors que l'on est dans cet état $E_2$, la pente du signal S devient supérieure à $\Delta P$, c'est-à-dire si la différence d'amplitude du signal S entre deux instants successifs devient supérieure à $\Delta P$, on passe dans l'état $E_4$ (c'est la transition $T_{24}$). Dans le cas contraire, on reste dans l'état $E_2$ (c'est la transition $T_{22}$).

L'organigramme décrit à la figure 3 est mis en œuvre dans le dispositif dont une représentation schématique est donnée à la figure 4. Il comprend un premier moyen 10 pour limiter la différence d'amplitude entre le signal S et le signal intermédiaire SI à une valeur prédéterminée $\Delta X$. Ce premier moyen 10 reçoit sur son entrée le signal S et est relié sur une autre entrée au signal intermédiaire SI. Ce dispositif comprend également un deuxième moyen 12 pour limiter la vitesse de variation de l'amplitude du signal SI à une valeur maximale prédéterminée $\Delta P$. Ce deuxième moyen 12 reçoit sur une entrée un courant d'intensité constante I dont le signe est déterminé par un moyen d'inversion 14. L'ensemble du premier moyen 10, du deuxième moyen 12 et du moyen d'inversion 14 constitue un moyen d'élaboration 15 qui délivre le signal intermédiaire SI. Le dispositif comprend en outre un comparateur 16 recevant sur une entrée inverseuse le signal S et sur une entrée noninverseuse le signal intermédiaire SI. Il délivre un signal binaire $\overline{SN}$ qui est identique au signe près au signal S non déformé. Le signal binaire $\overline{SN}$ est appliqué d'une part sur une entrée du moyen d'inversion 14 pour déterminer le signe du courant I délivré par ledit moyen d'inversion, et d'autre part sur l'entrée d'un inverseur 17 qui restitue le signal SN égal au signal S avant déformation.

On a représenté sur la figure 5 un mode de réalisation de ce dispositif. Le premier moyen 10 est constitué par deux diodes 18 identiques, en parallèle, l'anode d'une diode étant reliée à la cathode de l'autre diode. La valeur prédéterminée $\Delta X$ correspond à la chute de tension entre les bornes de chaque diode.

Le moyen d'inversion 14 est constitué par un générateur de courant délivrant un courant I constant dont le signe est déterminé par l'état du signal binaire $\overline{SN}$. Ce courant I, selon son signe, charge ou décharge un condensateur 20 de valeur C qui constitue le deuxième moyen 12. Ce deuxième moyen 12 permet de limiter la pente du signal intermédiaire SI à une valeur prédéterminée $\Delta P$ qui est égale au rapport $\dfrac{I}{C}$

Comme on peut le voir sur les signaux S et SI de la figure 1, les instants où ces deux signaux ont une même amplitude dépend de la pente maximale $\Delta P$ du signal intermédiaire SI, de la tension $\Delta X$, de la période T du signal émis et de l'amplitude du signal S. La pente $\Delta P$ et le niveau de S doivent donc être choisis pour un bon fonctionnement du dispositif et en particulier pour une bonne résistance aux éventuels signaux perturbateurs présents sur la ligne. L'expérience montre que l'on obtient un bon résultat avec les valeurs suivantes:

- la pente ΔP donnée par $\dfrac{I}{C} = \dfrac{2\Delta X}{T}$

- le niveau crête à crête du signal S mesuré entre deux crêtes consécutives séparées de la période T, compris entre 3.ΔX et 5.ΔX.

Le demandeur a réalisé un dispositif tel que représenté sur la figure 5. Ses caractéristiques sont: ΔX+0,7 volt, C=3,3 nf et I=1 mA. Le comparateur utilisé est du type LM 311. Ce dispositif a notamment été utilisé par le demandeur pour mettre en forme un signal binaire de débit 150 Kbit/s émis sous forme de signal bipolaire de tension ±2 v ayant été déformé par une ligne téléphonique constituée d'un câble métallique en cuivre de diamètre 0,4 mm. Entre la ligne et le dispositif décrit, le demandeur a inséré un amplificateur dont le gain est indépendant de la fréquence jusqu'à 150 kHz et qui compense l'affaiblissement du câble vers 80 kHz. La longueur du câble utilisé est de l'ordre de 4200 m. Pour des câbles de longueur inférieure, on peut insérer entre la ligne téléphonique et l'amplificateur un complément de ligne classique connu de l'homme de l'art. Le même dispositif a été aussi utilisé pour mettre en forme un signal binaire, émis en binaire, déformé par une ligne de zéro à 1000 m de câble téléphonique de diamètre ∅=0,4 mm sans égaliseur ni complément de ligne.

**Revendications**

1. Procédé pour remettre en forme un signal numérique déformé S, dans lequel on élabore, à partir du signal S, un signal analogique intermédiaire SI, la différence, en valeur absolue, entre l'amplitude du signal analogique SI et l'amplitude du signal S étant maintenue à une valeur au plus égale à une première valeur prédéterminée ΔX, et on compare lesdits signaux SI et S, le résultat de cette comparaison fournissant un signal binaire SN constituant une remise en forme du signal S, ledit procédé étant caractérisé en ce que ladite première valeur prédéterminée ΔX est inférieure à la valeur crête du signal S, et en ce que, en outre, on maintient la pente, en valeur absolue, du signal intermédiaire SI au plus égale à une deuxième valeur prédéterminée ΔP, tant que la différence des amplitudes des signaux SI et S reste, en valeur absolue, inférieure à ΔX, ladite deuxième valeur prédéterminée ΔP étant inférieure à la pente des transitions utiles du signal S et le signe de cette pente ΔP étant égal à celui du signe de la différence SI-S.

2. Procédé selon la revendication 1, caractérisé en ce que la valeur prédéterminée ΔX est inférieure à la moitié de la valeur crête du signal S.

3. Dispositif pour la mise en œuvre du procédé comprenant un moyen d'élaboration (15) d'un signal intermédiaire SI recevant sur une entrée le signal S et délivrant sur une sortie le signal intermédiaire SI, ledit moyen d'élaboration comprenant un premier moyen (10) pour limiter la différence entre l'amplitude du signal intermédiaire SI et l'amplitude du signal S à une première valeur prédéterminée ΔX, ledit premier moyen étant relié à l'entrée et à la sortie du moyen d'élaboration, ledit dispositif comprenant en outre un moyen de comparaison (16) recevant sur son entrée inverseuse le signal S et sur son entrée non-inverseuse le signal intermédiaire SI et délivrant un signal binaire SN appliqué sur l'entrée d'un inverseur (17) qui délivre le signal SN identique au signal S avant déformation, ledit dispositif étant caractérisé en ce que ladite valeur prédéterminée ΔX est inférieure à la valeur crête du signal S et en ce que ledit moyen d'élaboration est muni d'une entrée de commande et comprend en série un moyen d'inversion (14) et un deuxième moyen (12), l'entrée dudit moyen d'inversion étant reliée à l'entrée de commande du moyen d'élaboration (10) et la sortie du deuxième moyen (12) étant reliée à la sortie dudit moyen d'élaboration, ledit moyen d'inversion délivrant un courant d'intensité I constante et de signe fixé par l'état binaire du signal SN̄.

4. Dispositif selon la revendication 3, caractérisé en ce que le premier moyen (10) est constitué de deux diodes (18) identiques montées en parallèle, l'anode d'une diode étant reliée à la cathode de l'autre diode.

5. Dispositif selon la revendication 3, caractérisé en ce que le deuxième moyen (12) est constitué d'un condensateur (20) dont une extrémité est reliée à la sortie du moyen d'inversion (14) et du moyen d'élaboration (10) et dont l'autre extrémité est reliée à la masse.

**Patentansprüche**

1. Verfahren zur Regenerierung von verzerrten digitalen Signalen S, bei dem man ausgehend von dem Signal S ein analoges Zwischensignal SI herstellt, wobei der absolute Unterschiedswert zwischen der Amplitude des analogen Signals SI und der Amplitude des Signals S auf einem Wert gehalten wird, der höchstens gleich einem vorbestimmten ersten Wert ΔX ist, und man die Signale SI und S vergleicht, wobei das Vergleichsergebnis ein binäres Signal SN liefert, welches ein formmässig regeneriertes Signal S bildet, dadurch gekennzeichnet, dass der erste vorbestimmte Wert ΔX kleiner als der Spitzenwert des Signals S ist und dass man ferner den absoluten Steigungswert des Zwischensignals SI auf höchstens gleich einem zweiten vorbestimmten Wert ΔP hält, so lange der absolute Unterschiedswert der Amplituden der Signale SI und S kleiner als ΔX bleibt, wobei der zweite vorbestimmte Wert ΔP kleiner als die Steigung der nützlichen Übergänge des Signals S und das Vorzeichen dieser Steigung ΔP gleich dem Vorzeichen des Unterschiedes SI-S ist.

2. Verfahren nach Anspruch 1, dadurch gekennzeichnet, dass der vorbestimmte Wert ΔX kleiner als die Hälfte des Spitzenwertes des Signals S ist.

3. Vorrichtung zur Durchführung des Verfahrens mit einer Einrichtung (15) zum Erzeugen eines Zwischensignals (SI), die an einem Eingang das Signal S erhält und an einem Ausgang das Zwischensignal SI abgibt, wobei die Erzeugungseinrichtung eine erste Einrichtung (10) zum Begrenzen des Unterschiedes zwischen der Amplitude des Zwischensignals SI und der Amplitude des Signals S auf einen ersten vorbestimmten Wert ΔX aufweist, wobei die erste Einrichtung mit dem Eingang und dem Ausgang der Erzeugungseinrichtung verbunden ist, wobei die Vorrichtung ferner eine Vergleichseinrichtung (16) aufweist, die an ihrem invertierenden Eingang das Signal S und an ihrem nichtinvertierenden Eingang das Zwischensignal SI erhält und ein binäres Signal $\overline{SN}$ abgibt, welches an den Eingang eines Inverters (17) angelegt wird, der das Signal SN abgibt, das dem Signal S vor der Verzerrung identisch ist, dadurch gekennzeichnet, dass der erste vorbestimmte Wert ΔX kleiner als der Spitzenwert des Signals S ist und dass die Erzeugungseinrichtung mit einem Steuereingang versehen ist und in Reihe eine Invertereinrichtung (14) und eine zweite Einrichtung (12) umfasst, dass der Eingang der Invertereinrichtung mit dem Steuereingang der Erzeugungseinrichtung (10) und der Ausgang der zweiten Einrichtung (12) mit dem Ausgang der Erzeugungseinrichtung verbunden ist, und dass die Invertereinrichtung einen Strom mit konstanter Stärke I und einem Vorzeichen liefert, das durch den Zustand des binären Signals $\overline{SN}$ festgelegt ist.

4. Vorrichtung nach Anspruch 3, dadurch gekennzeichnet, dass die erste Einrichtung (10) von zwei identischen, parallel geschalteten Dioden (18) gebildet ist, wobei die Anode einer Diode mit der Kathode der anderen Diode verbunden ist.

5. Vorrichtung nach Anspruch 3, dadurch gekennzeichnet, dass die zweite Einrichtung (12) von einem Kondensator (20) gebildet ist, dessen einer Anschluss mit dem Ausgang der Invertereinrichtung (14) und der Erzeugungseinrichtung (10) und dessen anderer Anschluss mit Masse verbunden ist.

## Claims

1. Process for the restoration of a distorted digital signal S, in which there is produced, from the signal S, an intermediate analog signal SI, the difference, as an absolute value, between the amplitude of the analog signal SI and the amplitude of the signal S being maintained at a value at least equal to a first predetermined value ΔX, and the said signals SI and S are compared, the result of this comparison providing a binary signal SN constituting a restoration of the signal S, the said process being characterized in that the said first predetermined value ΔX is less than the peak value of the signal S, and in that, in addition, the slope, as an absolute value, of the intermediate signal SI is maintained at least equal to a second predetermined value ΔP, such that the difference in amplitudes of the signals SI and S remains, as an absolute value, less than ΔX, the said second predetermined value ΔP being less than the slope of the useful transitions of the signal S and the sign of this slope ΔP being equal to that of the sign of the difference SI-S.

2. Process according to Claim 1, characterized in that the predetermined value ΔX is less than half of the peak value of the signal S.

3. Device for the implementation of the process including a means (15) of producing an intermediate signal SI receiving on an input the signal S and delivering on an output the intermediate signal SI, the said means of production including a first means (10) of limiting the difference between the amplitude of the intermediate signal SI and the amplitude of the signal S to a predetermined value ΔX, the said first means being connected to the input and to the output of the means of production, the said device also including a means of comparison (16) receiving on its inverting input the signal S and on its non-inverting input the intermediate signal SI and delivering a binary signal $\overline{SN}$ applied to the input of an inverter (17) which delivers the signal SN identical to the signal S before distortion, the said device being characterized in that the said predetermined value ΔX is less than the peak value of the signal S and in that the said means of production is provided with a control input and includes in series a means of inversion (14) and a second means (12), the input of the said means of inversion being connected to the control input of the means of production (10) and the output of the second means (12) being connected to the output of the said means of production, the said means of inversion delivering a current I of constant value and of sign fixed by the binary state of the signal $\overline{SN}$.

4. Device according to Claim 3, characterized in that the first means (10) is formed of two identical diodes (18) connected in parallel, the anode of one diode being connected to the cathode of the other diode.

5. Device according to Claim 3, characterized in that the second means (12) is formed from a capacitor (20) of which one end is connected to the ouput of the means of inversion (14) and of the means of production (10) and of which the other end is connected to ground.

## FIG.1

## FIG.2

2,'2

# FIG.3

FIG.4

FIG.5